(19) Europäisches Patentamt
European Patent Office
Office européen des brevets

(11) **EP 1 288 670 B1**

(12) **EUROPÄISCHE PATENTSCHRIFT**

(45) Veröffentlichungstag und Bekanntmachung des Hinweises auf die Patenterteilung:
**13.02.2008 Patentblatt 2008/07**

(21) Anmeldenummer: **02014970.4**

(22) Anmeldetag: **09.07.2002**

(51) Int Cl.:
*G01R 33/485* [(2006.01)]    *G01R 33/561* [(2006.01)]

(54) **Ortsaufgelöste Kernspinresonanzspektroskopie mittels Steady State Signalen (SSFP)**

Localized NMR-spectroscopy using steady state signals (SSFP)

Spectroscopie RMN localisée utilisant des signaux stationnaires (SSFP)

(84) Benannte Vertragsstaaten:
**AT CH DE GB LI**

(30) Priorität: **08.08.2001 DE 10138961**

(43) Veröffentlichungstag der Anmeldung:
**05.03.2003 Patentblatt 2003/10**

(73) Patentinhaber: **Universitätsklinikum Freiburg**
**78106 Freiburg (DE)**

(72) Erfinder:
- **Hennig, Jürgen, Prof. Dr.**
  **79100 Freiburg (DE)**
- **Scheffler, Klaus**
  **4058 Basel (CH)**
- **Speck, Oliver**
  **79110 Freiburg (DE)**

(74) Vertreter: **Kohler Schmid Möbus**
**Patentanwälte**
**Ruppmannstrasse 27**
**70565 Stuttgart (DE)**

(56) Entgegenhaltungen:
- **1994, GILLIES R.J.: "NMR IN PHYSIOLOGY AND BIOMEDICINE", ACADEMIC PRESS , SAN DIEGO, CALIFORNIA , XP002279346 Chapter 10: Meyerhoff D.J., "Magnetic Resonance Spectroscopic Imaging" * Seite 169 - Seite 184 ***
- **HAACKE E M ET AL: "Steady-state free precession imaging in the presence of motion: application for improved visualization of the cerebrospinal fluid." RADIOLOGY. MAY 1990, Bd. 175, Nr. 2, Mai 1990 (1990-05), Seiten 545-552, XP009030529 ISSN: 0033-8419**
- **SPECK O ET AL: "FAST 31P CHEMICAL SHIFT IMAGING USING SSFP METHODS" ISMRM TENTH MEETING PROCEEDINGS, Bd. 10, 18. Mai 2002 (2002-05-18), Seite 792, XP008029271 HONOLULU,HI, USA**
- **SPECK O ET AL: "Fast /sup 31/P chemical shift imaging using SSFP methods" MAGN. RESON. MED. (USA), MAGNETIC RESONANCE IN MEDICINE, WILEY, USA, Bd. 48, Nr. 4, Oktober 2002 (2002-10), Seiten 633-639, XP002279345 ISSN: 0740-3194**

**Beschreibung**

Die Erfindung betrifft ein Verfahren der Magnetresonanz (=NMR) zur ortsaufgelösten Messung der Verteilung von NMR-Signalen von Metaboliten mit niedriger Signalintensität in Form eines CSI-Experiments, bei welchem auf ein Spinensemble eine Folge von in einem zeitlichen Abstand einer Wiederholzeit TR gegeneinander versetzten Hochfrequenz (=HF)-Impulsen angewendet wird und Magnet-Gradientenfelder geschaltet werden, von denen mindestens eines eine Ortskodierung der angeregten Spins bewirkt, wobei die Messung ohne Lesegradient erfolgt.

Ein solches Verfahren ist beispielsweise bekannt aus der Publikation von T.R. Brown et al. "NMR chemical shift imaging in three dimensions", Proc. Natl. Avad. Sci. USA, Vol. 79, 3523-3526 (1982).

Für die Messung der räumlichen Verteilung von Metaboliten wird heute nach dem Stand der Technik allgemein das sogenannte chemical shift imaging (CSI) Verfahren verwendet, welches auf der Aufnahme eines Signals durch Wiederholung einer Anregung mit entsprechenden Anregungspulsen erfolgt, welche zur Wahl eines Teilvolumens entsprechend örtlich selektiv ausgeführt werden können. Die Anregungsschritte werden dabei in einem zeitlichen Abstand TR wiederholt, wobei TR in der Größenordnung der longitudinalen Relaxationszeit T1 der beobachteten Metaboliten liegt, um Signalsättigung zu vermeiden. Die Aufnahme ist hierbei häufig sehr ineffizient, da der Signalzerfall mit der Zerfallskonstante T2* erfolgt, wobei T2* durch Magnetfeld-Inhomogenitäten bedingt sehr viel kleiner als TR ist, so dass die eigentliche Nutzzeit der Datenaufnahme gegenüber TR sehr klein ist.

Ein Verfahren zur demgegenüber deutlich besseren Effizienz der Signalaufnahme ist die von Carr 1958 vorgestellte Methode der Steady-State Free Precession (SSFP) (Carr HY, Phys.Rev. 112, 1693 (1958)). Hierbei wird durch Anwendung einer regelmäßigen Abfolge von Hochfrequenzimpulsen eine steady state Magnetisierung erzeugt, welche dann im Zeitinterval zwischen den Pulsen ausgelesen wird. Die Stärke der Magnetisierung hängt dabei von der Resonanzfrequenz der beobachteten Spins ab. In der bevorzugten Implementierung wird die Phase aufeinanderfolgender Pulse alterniert. Für Spins, welche im Zeitinterval TR zwischen zwei Pulsen eine Dephasierung um 180° erleben, wird das Signal dabei minimiert.

Für die MR-Bildgebung (also Messung der Protonendichte) ist dieses sogenannte trueFISP-Verfahren (auch balanced FFE oder FIESTA genannt) bereits etabliert (Oppelt A et al, electromedica 54, 15 (1986)) und wird gerade auf neuen Geräten oft angewandt, da durch die verfügbaren schnellen Gradientensysteme Wiederholzeiten von typischerweise TR< 5ms erreicht werden können, die kurz genug sind, um die Bildartefakte zu verhindern, welche durch die Signalauslöschung von Spins entstehen, die durch Feldinhomogenitäten eine Dephasierung erleiden.

So gibt es auch Ansätze, wie das Verhalten der Magnetisierung in der Übergangsphase vom Gleichgewichtszustand in den Steady State optimiert werden soll. Eingeführt ist hier eine Initialisierung mit einem Puls mit halbem Flipwinkel, der der nachfolgenden Sequenz im zeitlichen Abstand von vorzugsweise TR/2 vorangestellt wird (Deimling M, Heid O. Magnetization prepared true FISP imaging. In: Proceedings of the 2nd Annual Meeting of the Society of Magnetic Resonance, San Francisco, 1994. p 495.). Auch neuere Ansätze mit anderen Präparationsphasen sind bekannt.

Für Anwendungen in der Protonen-Bildgebung ist trueFISP daher als Methode zur sehr effizienten Datenaufnahme etabliert. Anwendungen zur lokalisierten Spektroskopie mit SSFP-Methoden und zur Messung der räumlichen Verteilung von Metaboliten wurden dahingegen bisher nicht berichtet, obwohl die geringe Effizienz der Datenaufnahme bei herkömmlichen Verfahren und die damit verbundenen langen Messzeiten das Hauptproblem der in vivo MR Spektroskopie darstellen.

Ursache hierfür ist die Tatsache, dass der SSFP-Signalmechanismus primär und augenscheinlich spektroskopische Information eliminiert, da Spins unabhängig von ihrer Resonanzfrequenz refokussiert werden und daher offenbar ununterscheidbar zum Gesamtsignal beitragen und die in der Spektroskopie erwünschte Unterscheidung von Spins unterschiedlicher chemischer Verschiebung (und damit unterschiedlicher Resonanzfrequenz) verloren geht.

Aufgabe der vorliegenden Erfindung ist es demgegenüber, ein Verfahren der eingangs beschriebenen Art so zu verbessern, dass die oben diskutierten Nachteile vermieden werden können. Insbesondere soll die Erfindung eine neue Methode vorstellen mit dem Ziel, dass die Vorteile von SSFP-Verfahren sich dennoch für spektroskopische Aufnahmen und insbesondere für chemical shift imaging anwenden lassen.

Erfindungsgemäß wird diese Aufgabe auf wirkungsvolle Art und Weise dadurch gelöst, dass die Wiederholzeit TR zwischen den anregenden HF-Impulsen höchstens in der Größenordnung der transversalen Relaxationszeit T2* der anzuregenden Spins eines Metaboliten gewählt wird und dass die Magnet-Gradientenfelder so gewählt werden, dass ihr Wirkungsintegral über eine Wiederholperiode der zeitlichen Länge TR Null ergibt, so dass eine NMR-Signalerzeugung nach dem Prinzip der Steady State Free Precession (=SSFP) erfolgt.

Eine gegenüber konventionellen CSI-Aufnahmen drastisch reduzierte Wiederholzeit TR sowie die Schaltung von integral vollständig balancierten Gradienten ermöglicht die Beibehaltung der spektroskopischen Informationen der chemical shift auch bei SSFP-Aufnahmen. Dadurch lassen sich die Vorteile von SSFP-Verfahren auch für die Spektroskopie nutzen.

Besonders bevorzugt ist eine Variante des erfindungsgemäßen Verfahrens, bei der die Wiederholzeit TR zwischen 1 und 100 ms, vorzugsweise zwischen 5 und 20 ms gewählt wird. Das Optimum in der Wahl der Wiederholzeit TR hängt von den übrigen experimentellen Parametern ab. Die oben genannten Werte gelten insbesondere bei der Anwendung eines homogenen NMR-Magnetfelds B in der Größenordnung von 1-2 Tesla.

Die Signalaufnamezeit TAQ wird in der Regel immer etwas kleiner als die Wiederholzeit TR sein. Das Signal-zu-Rausch-Verhältnis pro Zeiteinheit wird besonders groß, wenn die Signalaufnahmezeit TAQ knapp unterhalb TR, vorzugsweise bei TAQ $\leq$ 0,95 TR gewählt wird.

Bei einer Weiterbildung dieser Verfahrensvariante wird die Signal-Acquisition immer dann durchgeführt, wenn gerade keine HF-Impulse eingestrahlt werden. Auf diese Weise lässt sich das NMR-Signal im Hinblick auf eine Rauschminimierung optimieren.

In einer besonders bevorzugten Variante des erfindungsgemäßen Verfahrens werden HF-Impulse eingestrahlt und zeitlich veränderliche Magnet-Gradientenfelder zur Ortskodierung nach dem Prinzip der ortsaufgelösten Fourier Transformationsmethode gewählt. Damit lassen sich aus den aufgenommen NMR-Signalen besonders einfach ortsaufgelöste Bilder der Metaboliten rekonstruieren.

Bei einer weiteren bevorzugten Verfahrensvariante wird durch Schaltung eines Magnet-Gradientenfeldes gleichzeitig mit der Einstrahlung der anregenden HF-Impulse das Anregungsvolumen räumlich eingeschränkt. Dies ermöglicht auf einfache Weise eine gezielte Beschränkung der NMR-Messung auf bestimmte Teile des Messobjekts, wobei Störungen und Rauschanteile außerhalb der interessanten Zone aus den Signalen herausgehalten werden können.

Eine Weiterbildung dieser Verfahrensvariante zeichnet sich dadurch aus, dass die Richtung und Amplitude des Schichtselektionsgradienten von einem Aufnahmeschritt zum nächsten verändert wird, und damit eine weitere Einschränkung des Messvolumens auf den Bereich, in welchem die SSFP-Bedingung erfüllt ist, erfolgt. Dadurch lässt sich das interessierende Messvolumen in mehreren Dimensionen einschränken, so dass eine gezielte Selektion ganz bestimmter Subvolumina im Messobjekt ermöglicht wird.

Bei einer weiteren besonders bevorzugten Variante des erfindungsgemäßen Verfahrens wird die NMR-Aufnahme unter Variation der Messfrequenz mehrfach wiederholt wird, so dass sich über die gemessene Signalintensität als Funktion der Messfrequenz die Signal-Intensitäten mehrerer NMR-Signale unterschiedlicher Resonanzfrequenz in charakteristischer Weise überlagern.

Alternativ oder ergänzend dazu sieht eine weitere Verfahrensvariante vor, dass die NMR-Aufnahme unter Variation eines Phaseninkrements zwischen aufeinanderfolgenden HF-Impulsen mehrfach wiederholt wird, so dass sich über die gemessene Signal-Intensität als Funktion des Phaseninkrements zwischen aufeinanderfolgenden HF-Impulsen die Signalintensitäten mehrerer NMR-Signale unterschiedlicher Resonanzfrequenz in charakteristischer Weise überlagern.

Bei beiden Verfahrensvarianten (und auch bei Kombinationen davon) lassen sich dann durch an sich bekannte Rechenverfahren die den einzelnen Resonanzen zugeordneten Signal-Intensitäten bestimmen.

Bei einer weiteren vorteilhaften Variante des erfindungsgemäßen Verfahrens werden HF-Impulse mit alternierendem Flipwinkel $\alpha$ bzw. Phaseninkremente von 180° gewählt. Damit lässt sich in der Regel die höchstmögliche Signal-Intensität erreichen.

Vorteilhaft ist auch eine Variante des erfindungsgemäßen Verfahrens, bei der HF-Impulse mit einem solchen Flipwinkel $\alpha$ gewählt werden, dass $\cos \alpha = (T1/T2 - 1)/(T1/T2 + 1)$, wobei T1 die longitudinale Relaxationszeit und T2 die transversale Relaxationszeit ohne Berücksichtigung von Suszeptibilitätseffekten bedeuten. Bei Metaboliten, bei denen T1 und T2 bekannt sind, kann damit das NMR-Signal maximiert werden.

Weitere Vorteile der Erfindung ergeben sich aus der Beschreibung und der Zeichnung. Ebenso können die vorstehend genannten und die noch weiter aufgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Die Erfindung ist in der Zeichnung dargestellt und wird anhand von Ausführungsbeispielen näher erläutert.

Im Einzelnen zeigen die Abbildungen Folgendes:

Fig.1    trueFISP-Verfahren nach dem Stand der Technik: rf kennzeichnet die Hochfrequenzimpulse mit Flipwinkel $\alpha$ und Phase $\phi$, sowie das innerhalb der Akquisitionszeit TAQ aufgenommene Signal, GS, GR und GP kennzeichnen den Schichtselektions-, Lese- und Phasengradienten.

Fig.2    SSFP-Verfahren mit 2D-CSI-Kodierung gemäß der Erfindung:
a) Die Aufnahme erfolgt spektroskopisch und ohne Gradient, eine zwei-dimensionale Ortskodierung erfolgt durch sukzessive Variation von GP1 und GP2 in jeweils orthogonaler Richtung.
b) trueFISP-Verfahren mit 3D-CSI-Kodierung: Die Aufnahme erfolgt spektroskopisch und ohne Gradient, eine drei-dimensionale Ortskodierung erfolgt durch sukzessive Variation von GP1, GP2 und GP3 in jeweils orthogonaler Richtung.

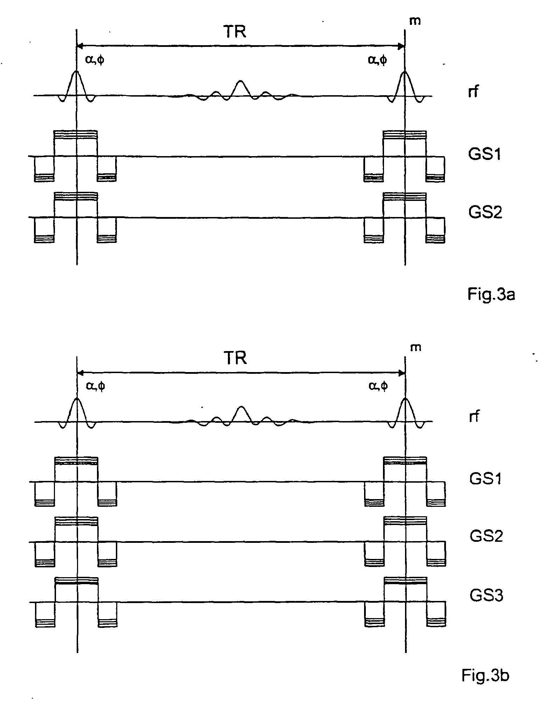

Fig.3 SSFP-Verfahren zur Selektion eines Teilvolumens mittels Schichtselektionsgradient gemäß der Erfindung. Bei Fig.3a) werden in sukzessiven Aufnahmen zwei orthogonale Schichten variiert, in Fig.3b) erfolgt eine weitere Eingrenzung durch Variation der Schichtselektionsgradienten in allen 3 Raumrichtungen.

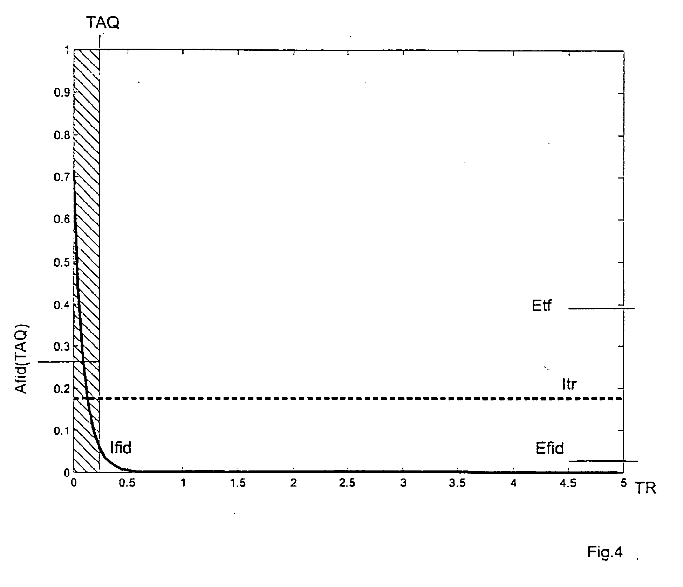

Fig.4 Vergleich der Aufnahme mit SSFP und konventioneller Aufnahme für T1= 4s, T2= 500 ms, T2*= 50ms, TR= 5s, TAQ für die konventionelle Aufnahme=60 ms (entspricht maximalem Signal zu Rausch). Das FID-Signal Ifid ist durch den dicken durchgezogenen exponentiellen Signalzerfall gekennzeichnet, die SSFP-Amplitude Itr entspricht der dicken gestrichelten Linie. Die Parameter entsprechen der Messung von Phosphokreatin in der in vivo 31 P-Spektroskopie. Das Effizienzverhältnis Etf/Efid berechnet sich zu 14:1, mit f=TAQ/TR=0.7 für die SSFP-Akquisition ist Etf/Efid ~ 10. Die schraffierte Fläche gibt die Aufnahmedauer des FID wieder, bei längerem TAQ sinkt das S/N. Afid(TAQ) ist der Mittelwert der FID-Amplitude über TAQ.

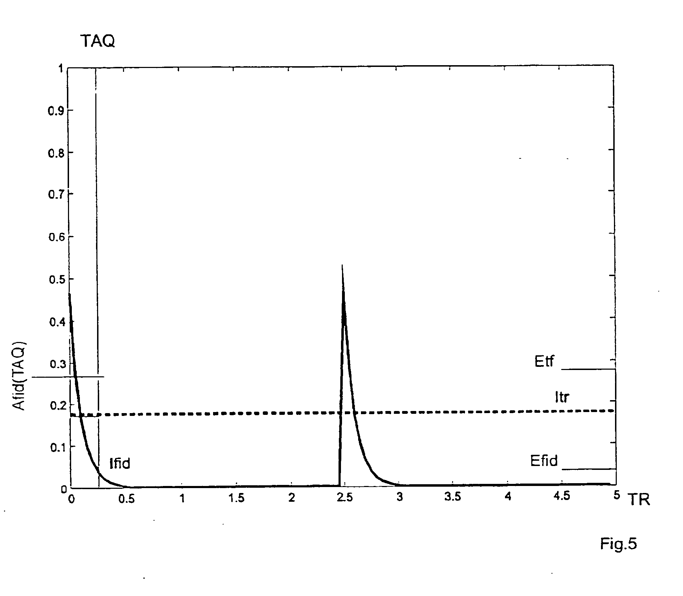

Fig.5 Aufnahme mit Parametern wie in Fig.4, jedoch mit TR=2.5 s. Durch die kurze Wiederholzeit wird zwar die Signalamplitude Ifid reduziert, die Effizienz der FID-Aufnahme wird dennoch durch die doppelte Zahl der FIDs pro Zeiteinheit gesteigert.
Etf/Efid beträgt ~ 8 bei f=1.

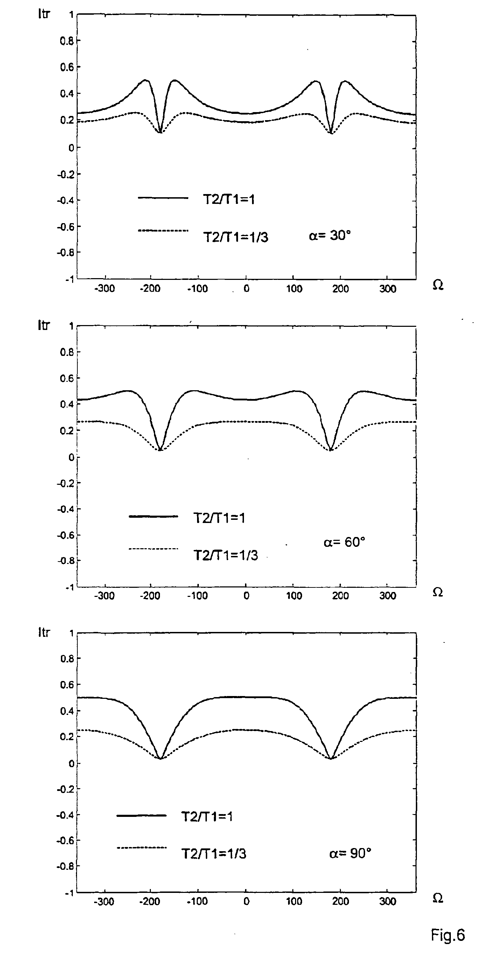

Fig.6 Betrag der Signalintensität Abs(Itr) der SSFP-Sequenz als Funktion der off-Resonanzfrequenz $\Omega$ für Flipwinkel $\alpha$=30°(oben), 60°(Mitte) und 90°(unten) für unterschiedliche Verhältnisse von T2/T1 und bei Aufnahme mit alternierender Pulsphase. Man sieht, dass die Form von Itr($\Omega$) nur wenig vom T2/T1-Verhältnis abhängt.

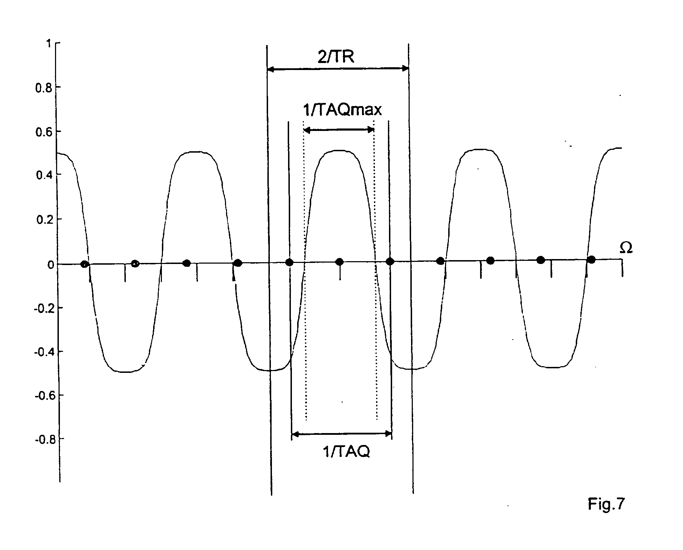

Fig.7 Spektrale Auflösung der SSFP-CSI-Aufnahme: Die spektrale Auflösung ist durch 1/TAQ bestimmt, das Raster der Spektrenaufnahme ist durch dicke Punkte markiert. Die jeweils gemessenen Signalintensitäten werden durch die Abhängigkeit von der Resonanzfrequenz bestimmt, d.h. die Signalintensitäten sind entsprechend moduliert. Im Gegensatz zu Fig.6 ist die Modulationsfunktion selbst und nicht ihr Betrag dargestellt, um die periodische Inversion der Signale aufzuzeigen.

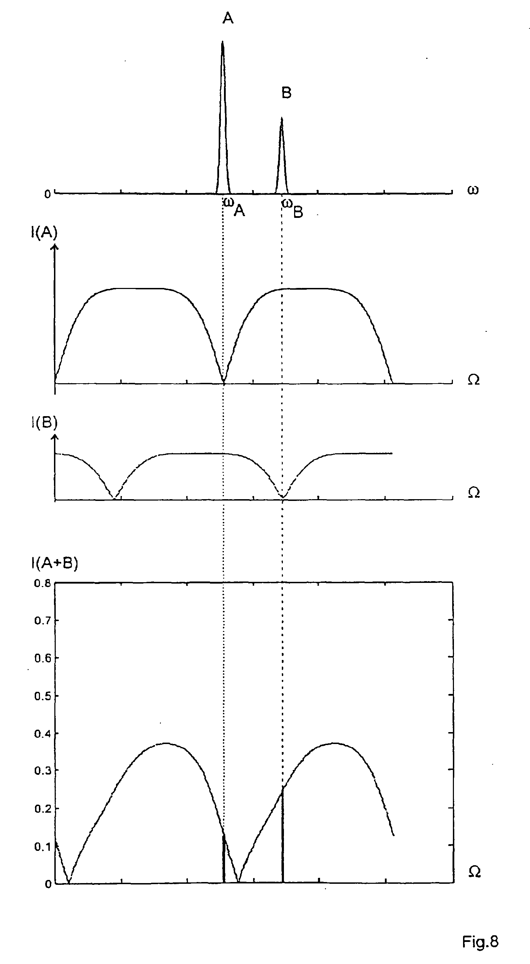

Fig.8 Aufnahme der Signale zweier Metaboliten A und B mit den Resonanzfrequenzen $\Omega_A$ und $\Omega_B$. Die Aufnahme kann so durchgeführt werden, dass das Signal jeweils eines Metaboliten gleich 0 wird.

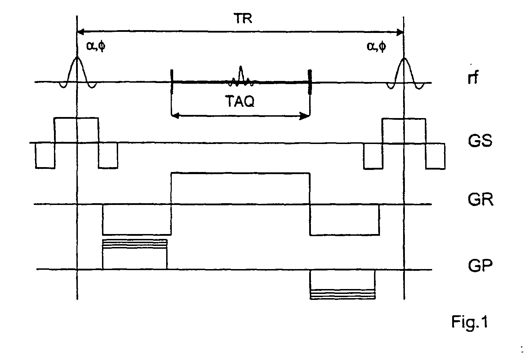

Das trueFISP-Verfahren für Protonenbildgebung entsprechend dem Stand der Technik ist in Fig.1 gezeigt. Die Hochfrequenzimpulse mit Flipwinkel $\alpha$ und Phase $\phi$ sind zur Aufnahme als Schichtselektionspulse in Verbindung mit dem Lesegradient GS als selektive Pulse ausgelegt, die Phasen $\phi$ aufeinanderfolgender Pulse unterscheiden sich vorzugsweise um 180°, z.B. $\phi u$(ungerade Aufnahmeperiode)=0° und $\phi g$(gerade Aufnahmeperiode)=180°.

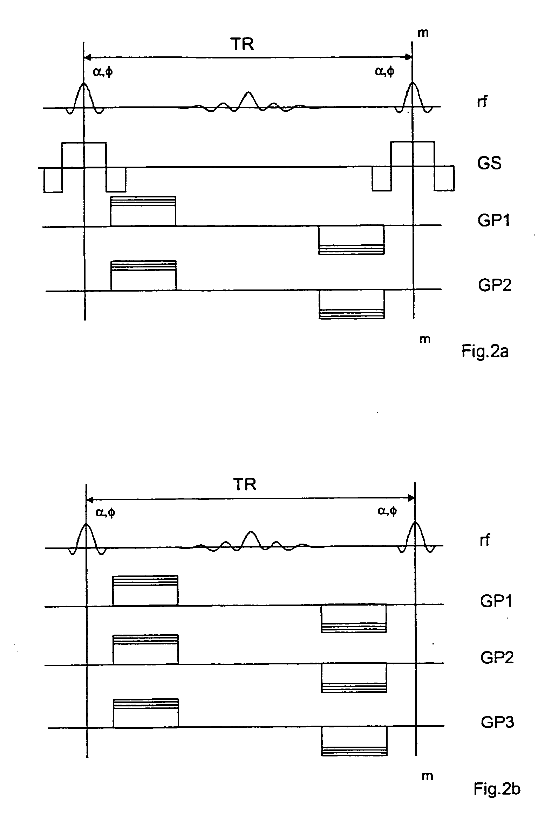

Zur Anwendung des trueFISP-Verfahrens für die Aufnahme als 1-, 2- oder 3-dimensionales chemical shift imaging (CSI)-Verfahren wird die Aufnahme ohne Lesegradient durchgeführt und eine Ortskodierung durch Phasengradienten in 1-, 2- oder 3 Raumrichtungen ersetzt. Der Anregungspuls kann dabei entweder durch Anlegen eines entsprechenden Gradienten während des Pulses schichtselektiv erfolgen (Für den Fall einer 2D-CSI Kodierung in Fig.2a gezeigt), bei 3D-CSI Kodierung (Fig.2b) kann die Schichtselektion auch entfallen.

Eine weitere Einschränkung des Volumens, innerhalb dessen die oben genannte Bedingung zur Erzeugung eines steady state-Signals durch alternierende Pulsphasen in aufeinanderfolgenden Pulsen innerhalb eines quader- oder zylinderförmigen Teilvolumens erreicht wird, ist dann gegeben, wenn die Schichtselektion in aufeinander folgenden Pulsen variiert wird (Fig.3a).

Im einfachsten Fall werden aufeinander folgende Pulse mit alternierender Phase auf jeweils orthogonale Schichten angewendet. Die SSFP-Bedingung ist dann nur für die Spins im Schnittvolumen der beiden Schichten erfüllt. Formal entspricht diese Alternierung der Schichtebene einer Aufnahme mit einer Rotation der Schichtebene von einer Anregung zur nächsten um $\Delta\Phi_s$ = 90°. Durch Wahl anderer Werte für $\Delta\Phi_s$ entsprechend einer langsameren Rotation der Schichtebene können entsprechend anders geformte zylindrische Anregungsvolumina selektiert werden. Für $GS1^2+GS2^2=1$ ist die Dicke der ausgewählten Schicht immer identisch und das ausgewählte Volumen wird isotrop in Richtung von GS1 und GS2.

Schließlich lässt sich auch (Fig.3b) ein würfel- oder kugelförmiges Volumen durch Anlegen von variablen Schichtselektionsgradienten in allen drei Raumrichtungen anlegen. Mit $GS1^2+GS2^2+GS3^2=1$ wird so ein kugelförmiges Volumen selektiert. Vorteilhaft hierbei ist es, wenn die Länge eines Aufnahmezyklus unter unterschiedlichen Gradienten geradzahlig ist, da sich dann die Bedingung der Phasenalternierung im Zielgebiet am einfachsten realisieren lässt.

Die Position des nach einem der beschriebenen Schritte definierten Volumens lässt sich schließlich über entsprechende Wahl der Frequenz der Anregungspulse beliebig im Raum positionieren. Die unterschiedlichen Möglichkeiten der Definition des Erfassungsvolumens durch die Schichtselektion lässt sich in beliebiger Weise mit der Art der Ortskodierung entsprechend den Figuren 2a und 2b kombinieren, um innerhalb der selektierten Teilvolumina eine örtliche Auflösung zu erzielen.

Die Akquisitionszeit TAQ ist kleiner als TR. TR wird im allgemeinen kurz gewählt (im Bereich einiger ms), um suszeptibilitätsbedingte Phaseneffekte, welche die SSFP-Bedingung stören, zu minimieren. Bei n1 Datenpunkten, welche innerhalb TAQ aufgenommen werden, wird die Aufnahmebandbreite BW = n1 /TAQ dementsprechend groß. Zur Kodierung eines 2-dimensionalen Bildes mit np1 Phasenkodierschritten in Richtung GP1 und np2=n1 Schritten in Richtung GP2 sind dann np1 x np2 Aufnahmeschritte nötig entsprechend einer Gesamtaufnahmezeit Tges von np1 x np2 x TR.

Betrachtet man das Signal-zu-Rausch Verhältnis pro Zeiteinheit einer Aufnahme mit konventionellem trueFISP mit Auslesen durch einen Lesegradienten entsprechend Fig.1 und einer CSI-Phasenkodierung (Fig.2a), so sind diese nach den Grundtheoremen der Signaltheorie zunächst identisch:

Bei der konventionellen Aufnahme mit n1 Punkten werden np2 Aufnahmen wiederholt, um dieselbe Messzeit von np1 x np2 x TR der Aufnahme mit CSI-Kodierung entsprechend Fig.1b zu erreichen. Entsprechend BW = n1 /TAQ ist das Signal-zu-Rausch Verhältnis gegenüber der CSI-Aufnahme damit pro Aufnahmeschritt um einen Faktor √n1 erniedrigt, bei n1-facher Mittelung wird dieser Faktor gerade wieder kompensiert.

Ein Vorteil der CSI-Kodierung ergibt sich jedoch dann, wenn die durch TAQ bestimmte Bandbreite pro Pixel dwp=1/TAQ größer ist als die Linienbreite der beobachteten Resonanzen. Bei typischen Werten für TAQ im Bereich weniger ms liegt die Bandbreite pro Pixel im Bereich von mehreren hundert Hz gegenüber einer im wesentlichen durch Magnetfeld-Inhomogenitäten bestimmten Linienbreite von 5-10 Hz. Die Linie wird bei Ortskodierung mit einem Lesegradienten (Fig.1) daher quasi über das gesamte Pixel verschmiert.

Bei Aufnahme mittels Phasenkodierung (Fig.2a) wird dagegen die Signal-Intensität durch die spektrale Auflösung auf die Resonanzfrequenz fokussiert und damit alle Rauschbeiträge außerhalb des Resonanzsignals separiert, was zu einer deutlichen Verbesserung des Signal-zu-Rausch Verhältnisses führt.

Ein weiterer Vorteil der spektralen Aufnahme ergibt sich aus der Signal-Intensität als Funktion der off-Resonanz Frequenz. Auf Grund der endlichen Länge der Pulse und Phasenkodiergradienten ist TAQ=f*TR mit f<1. Die spektrale Auflösung SW der Datenaufnahme ergibt sich nach dem Nyquist-Theorem für komplexe Signale zu SW = 1/TAQ. Dementsprechend lassen sich Signale, deren Resonanzfrequenz sich um 1/TAQ unterscheidet, getrennt aufnehmen und ihre Verteilung so separat bestimmen.

In der in den Figuren 2a und 2b gezeigten Weise kann das Verfahren bereits als CSI-Methode zur Messung der Gesamtintensität sämtlicher Signale der beobachteten Spinspezies angewendet werden. Für die konventionelle Protonenbildgebung basierend auf den dominanten Signalanteilen von Wasser und Fett ist dies im allgemeinen nicht sinnvoll, da für hochaufgelöste Bilder etwa mit einer Matrixgröße 128 x 128 selbst bei TR=2-4 ms die Gesamtaufnahmezeit Tges in den Bereich einer Minute kommt und ein konventionelles trueFISP-Experiment in n1-fach schnellerer Aufnahme bereits ein hinreichendes Signal-zu-Rausch Verhältnisses liefert.

Für CSI-Anwendungen zur Beobachtung von Metabolitensignalen und insbesondere von Signalen anderer Kerne hingegen lässt sich die CSI-Aufnahme nutzbringend einsetzen. Eine bevorzugte Anwendung dabei ist etwa die Anwendung in der Phosphorspektroskopie, welche in der in vivo-Anwendung vor allem zur Untersuchung des Energiestoffwechsels sowie des Phosphorester-Metabolismus angewendet wird. Von den im in vivo-Spektrum beobachteten Resonanzen sind insbesondere die Signale von Phosphomonoestern sowie das Phosphokreatin für die Beobachtung mit SSFP geeignet, da sie ein relativ günstiges T2/T1-Vehältnis aufweisen.

Im folgenden soll die Effizienz der Datenaufnahme gegenüber konventioneller Aufnahme mittels CSI mit langem TR verglichen werden:

Für den Fall, dass T2*-Effekte vernachlässigt werden können und für TR<T1,T2, ist die Signalintensität Itf einer SSFP- Aufnahme für on-resonance Spins gegeben durch

$$Itf= I0*sin(\alpha)/(1+T2/T1+cos(\alpha)*(1-T2/T1)) \qquad\qquad [1]$$

Wobei I0 das durch die Spindichte gegebene Gleichgewichtssignal wiedergibt, $\alpha$ ist der Flipwinkel der Pulse. Aus Gl.[1] folgt, dass I vor allem für große Werte von T2/T1 groß wird, auf Grund von T2<T1 wird der Maximalwert für I bei T2=T1 erreicht.

Die Aufnahme mittels SSFP-CSI stellt daher eine Möglichkeit zur räumlich aufgelösten selektiven spektroskopischen Beobachtung von schmalen Resonanzen (=relativ langes T2) dar.

Zum Vergleich der Effizienz der Aufnahme mit konventioneller spektroskopischer Aufnahmetechnik muss die durch Gleichung [1] gegebene Intensität in Bezug gesetzt werden zur Intensität bei mehrfacher Wiederholung der Aufnahme eines freien Induktionszerfalls (FID), wie er in der Spektroskopie Anwendung findet. Bei einer Wiederholzeit TR und einer Zerfallszeit T2* ist die Intensität Ifid gegeben durch

$$Ifid = Iss \exp(-t/T2^*) \qquad [2]$$

Iss ist dabei die steady state Intensität entsprechend

$$Iss = I0 \, (1-\exp(-TR/T1)) \qquad [3]$$

Die Signalamplitude Ass ergibt sich durch Integration über Ifid über die Aufnahmezeit TAQ aus den Gleichungen [2] und [3]:

$$Ass = I0 \, T2^* \, (1-\exp(-TR/T1))(1-\exp(-TAQ/T2^*)) \qquad [4]$$

Das Signal-zu-Rausch Verhältnis berechnet sich dann zu

$$Sfid = Ass/\sqrt{TAQ}. \qquad [5]$$

Sfid nimmt mit steigendem TAQ zunächst zu, bei langem TAQ jedoch wieder ab, da dann das mit T2* zerfallende Signal gegenüber dem konstanten Rauschen klein wird. Es lässt sich zeigen, dass die maximale mittlere Signalamplitude etwa 57% von Iss beträgt. Gemittelt über die gesamte Aufnahmezeit ergibt sich aus [2]-[5] eine mittlere Signalausbeute Efid der Aufnahme von

$$Efid = Sfid^*TAQ/TR = I0 \, T2^* \, (1-\exp(-TR/T1))(1-\exp(-TAQ/T2^*)) \, \sqrt{TAQ}/TR \qquad [6]$$

Wählt man die Akquisitionszeit der SSFP-Aufnahme so kurz, dass T2*-Effekte vernachlässigt werden können, so ergibt sich die entsprechende Signalausbeute des trueFISP-Signals bei Akquisition über dieselbe Zeit TR entsprechend Gleichung [1] zu

$$Etf = f \, Itf \, \sqrt{TR} = f \, I0^*\sin(\alpha)/(1+T2/T1+\cos(\alpha)^*(1-T2/T1)) \, \sqrt{TR} \qquad [7]$$

f ist dabei ein Faktor, welcher angibt, welcher Anteil der gesamten Messzeit bei der trueFISP-Aufnahme für die Datenakquisition verwendet wird. Für sehr kurze Pulsabstände wird f~0.5, da dann die Dauer der Pulse und der Phasenkodiergradienten zu TAQ vergleichbar wird. Für längere Intervalle wird f~1.

Ein Vergleich von Gleichung [6] und Gleichung [7] zeigt, dass die beiden Verfahren in sehr unterschiedlicher Weise von den physikalischen Parametern T1, T2 und T2* abhängen. So zeigt Fig.4, dass für Aufnahmeparameter, wie sie für Metabolitenspektroskopie typisch sind, die Signalausbeute der trueFISP-Aufnahme mehr als 10 mal größer ist als bei konventioneller Spektrenakquisition ! Dies entspricht einer Reduktion der Messzeit um mehr als einen Faktor 100 zur Erzielung desselben Signal-zu-Rausch Verhältnisses.

Eine Verschiebung der Effizienz findet dann statt, wenn das T1 des untersuchten Metaboliten kurz ist und entsprechende kurze Wiederholzeiten zur Datenaufnahme gewählt werden (siehe Fig.5). Bei Verwendung sehr kurzer Wiederholzeiten in der konventionellen Aufnahmetechnik wird die Signalausbeute Efid zwar erhöht, allerdings begünstigen diese Parameter vor allem die Signale von Spins mit kurzem T1, was in der Metaboliten-Spektroskopie für Moleküle mittlerer Größe (~ 1000-10000 atomare Einheiten) gilt, welche unspezifischen Substanzen zugeordnet werden und deren Messung häufig unerwünscht ist. TrueFISP bewirkt daher eine hohe Signalausbeute vor allem für Signale mit schmalen Linien.

Die Aufnahme mit trueFISP erbringt daher gegenüber der konventionellen Aufnahme vor allem für Metabolite mit relativ langem T2 (=scharfe Linien) einen erheblichen Signalgewinn gegenüber konventioneller Spektroskopie. Aus den Gleichungen [6] und [7] wird deutlich, dass trueFISP besonders vorteilhaft ist, wenn T2*<T2, also zur Beobachtung der Signale kleiner Metaboliten mit langem T2.

Die bevorzugte Anwendung bezieht sich daher auf die Beobachtung von Signalen mit T2>T2*, d.h. die Linienbreite ist durch Magnetfeld-Inhomogenitäten und Suszeptibilitätseffekte bestimmt und nicht durch T2. Zudem muss festgehalten werden, dass die obige Berechnung T2*-Effekte über die Akquisitionszeit der SSFP-Aufnahme vernachlässigt, d.h. TAQ<T2*.

Die Unterscheidung unterschiedlicher Metabolite gelingt entsprechend dem Prinzip des chemical shift imaging über die Fourier Transformation des aufgenommenen steady state Signals. Entsprechend dem Nyquist Theorem ist dabei die spektrale Auflösung dw = 1/TAQ, die Bandbreite der Aufnahme ergibt sich zu n1*dw. Im praktisch nicht realisierbaren Grenzfall, wenn die Dauer der Hochfrequenzpulse sowie der Phasenkodiergradienten vernachlässigt wird, wird TAQmax=TR und damit dwmax=1/TR. Im Gegensatz zu konventioneller Aufnahme muss berücksichtigt werden, dass die Signalamplitude entsprechend der in Fig.6 gezeigten Abhängigkeit von $\Omega$ moduliert ist. Für TAQ<TR ergibt sich das in Fig.7 gezeigte Abbildungsraster. Zur Optimierung des S/N wird die SSFP-Aufnahme typischeweise mit einer Wiederholzeit im Beeich von 1-50 ms durchgeführt, dw liegt damit im Bereich von ca. 20-1000 Hz. Dies macht deutlich, dass SSFP-CSI gegenüber herkömmlichem CSI eine deutlich schlechtere spektrale Auflösung hat.

Eine Verbesserung der spektralen Auflösung ist jedoch über die Abhängigkeit der Signalintensität von der off-Resonanz Frequenz möglich. Wird die Aufnahme mit unterschiedlicher Aufnahmefrequenz wiederholt, so entspricht dies einer Verschiebung des in Fig.7 gezeigten Aufnahmerasters gegenüber der SSFP-Modulation.

Dabei kann eine Änderung der jeweiligen Trägerfrequenz um $\Delta\Omega$ ohne weiteres in ein Phaseninkrement der Phase aufeinanderfolgender Pulse umgerechnet werden. So ist eine Aufnahme mit einer gegenüber der Resonanzfrequenz um $\Delta\Omega$ verschobenen Frequenz bei identischer Pulsphase im Signalverhalten identisch zu einer Aufnahme on-Resonanz($\Delta\Omega$ =0), aber mit einem linearen Phaseninkrement $\Delta\Phi$ (in Radian) entsprechend

$$\Delta\Phi= 2\pi\ TR/\Delta\Omega \qquad\qquad\qquad [9]$$

Wie in Fig.6 gezeigt, ergibt sich insbesondere für eine off-Resonanz Frequenz

$$\Omega 0 = 1/(2TR) \qquad\qquad\qquad [10]$$

bei alternierender Pulsphase eine Signalauslöschung. Dies entspricht $\Omega$ = 0 (=on-Resonanz) bei konstanter Pulsphase. Dementsprechend lässt sich dann die Lage der Resonanzfrequenzen über die Signalmodulation als Funktion der Aufnahmefrequenz (oder des Phaseninkrements) bestimmen.

Durch Aufnahme auf selektierten Messfrequenzen, welche interessierenden Signalen entsprechen oder auch durch sukzessive Aufnahme über einen interessierenden Bereich von Messfrequenzen können so die Intensitäten der jeweiligen Einzelsignale bestimmt werden.

Zur Aufnahme von chemical shift selektiven Bildern der Verteilung von Metaboliten mit bekannter Resonanzfrequenz, kann dann in einer bevorzugten Implementierung die Aufnahme so erfolgen, dass die Aufnahme in mehreren Aufnahmeschritten so erfolgt, dass in jeder Einzelaufnahme jeweils ein Signal unterdrückt oder minimiert wird (Fig.8). Die gemessene Signalintensität spiegelt dann die Summe der Intensitäten der jeweils anderen Signale innerhalb des Auflösungsbereichs wieder.

Ist die Zahl und genaue Lage der Linien des zu beobachteten Spektrums nicht bekannt, so wird die Aufnahme so durchgeführt, dass durch entsprechende Wahl der Aufnahmebedingungen die Signalintensität als Funktion von $\Omega$ gemessen wird. Lage, Intensität und Anzahl der Einzellinien des Spektrums ist dann über entsprechende Algorithmen als lineare Superposition von jeweils einzelnen Signalverläufen berechenbar.

Die Signalbeiträge einzelner Resonanzen lässt sich dann durch Lösung des sich ergebenden Gleichungssystems entsprechend der Superposition der Beiträge der einzelnen Signale nach einem der gängigen Verfahren zur Lösung linearer Gleichungssysteme (Regression, Marquardt-Algorithmus etc.) ermitteln.

Schließlich lassen sich Signale unerwünschter Resonanzen (z.B: Fett- und/oder Wassersignale bei Protonen-CSI) nach dem Stand der Technik dadurch unterdrücken, dass die Aufnahme zum einen so erfolgt, dass die Modulationsfunktion entsprechend Fig.7 für diese Signale am Nulldurchgang ist. Zudem können während der Sequenz entsprechende Hochfrequenzpulse zur zusätzlichen Unterdrückung dieser Signale angewendet werden.

**Patentansprüche**

1. Verfahren der Magnetresonanz (=NMR) zur ortsaufgelösten Messung der Verteilung von NMR-Signalen von Metaboliten mit niedriger Signalintensität in Form eines CSI-Experiments, bei welchem auf ein Spinensemble eine Folge von in einem zeitlichen Abstand einer Wiederholzeit TR gegeneinander versetzten Hochfrequenz (=HF)-Impulsen angewendet wird und Magnet-Gradientenfelder geschaltet werden, von denen mindestens eines eine Ortskodierung der angeregten Spins bewirkt, wobei die Messung ohne Lesegradient erfolgt,
**dadurch gekennzeichnet,**
**dass** die Wiederholzeit TR zwischen den anregenden HF-Impulsen höchstens in der Größenordnung der transversalen Relaxationszeit T2* der anzuregenden Spins eines Metaboliten gewählt wird,
**dass** die Magnet-Gradientenfelder so gewählt werden, dass ihr Wirkungsintegral über eine Wiederholperiode der zeitlichen Länge TR Null ergibt, so dass eine NMR-Signalerzeugung nach dem Prinzip der Steady State Free Precession (=SSFP) erfolgt.

2. Verfahren nach Anspruch 1, **dadurch gekennzeichnet, dass** Wiederholzeit TR zwischen den anregenden HF-Impulsen bei etwa T2* /10 gewählt wird.

3. Verfahren nach einem der vorhergehenden Ansprüche, **dadurch gekennzeichnet, dass** die Wiederholzeit TR zwischen 1 und 100 ms, vorzugsweise zwischen 5 und 20 ms gewählt wird.

4. Verfahren nach einem der vorhergehenden Ansprüche, **dadurch gekennzeichnet, dass** die Signalaufinahmezeit TAQ $<\approx$ TR gewählt wird, vorzugsweise TAQ $\leq$ 0,95 TR.

5. Verfahren nach Anspruch 4, **dadurch gekennzeichnet, dass** eine NMR-Signal-Akquisition immer dann durchgeführt wird, wenn keine HF-Impulse eingestrahlt werden.

6. Verfahren nach einem der vorhergehenden Ansprüche, **dadurch gekennzeichnet, dass** HF-Impulse und zeitlich veränderliche Magnet-Gradientenfelder zur Ortskodierung nach dem Prinzip der ortsaufgelösten Fourier Transformationsmethode gewählt werden.

7. Verfahren nach einem der vorhergehenden Ansprüche, **dadurch gekennzeichnet, dass** durch Schaltung eines Magnet-Gradientenfeldes gleichzeitig mit der Einstrahlung der anregenden HF-Impulse das Anregungsvolumen räumlich eingeschränkt wird.

8. Verfahren nach Anspruch 7, **dadurch gekennzeichnet, dass** die Richtung und Amplitude des Schichtselektionsgradienten von einem Aufnahmeschritt zum nächsten verändert wird, und damit eine weitere Einschränkung des Messvolumens auf den Bereich, in welchem die SSFP-Bedingung erfüllt ist, erfolgt.

9. Verfahren nach einem der vorhergehenden Ansprüche, **dadurch gekennzeichnet, dass** die NMR-Aufnahme unter Variation der Messfrequenz mehrfach wiederholt wird, so dass sich über die gemessene Signalintensität als Funktion der Messfrequenz die Signalintensitäten mehrerer NMR-Signale unterschiedlicher Resonanzfrequenz in charakteristischer Weise überlagern.

10. Verfahren nach einem der vorhergehenden Ansprüche, **dadurch gekennzeichnet, dass** die NMR-Aufnahme unter Variation eines Phaseninkrements zwischen aufeinanderfolgenden HF-Impulsen mehrfach wiederholt wird, so dass sich über die gemessene Signalintensität als Funktion des Phaseninkrements zwischen aufeinanderfolgenden HF-Impulsen die Signalintensitäten mehrerer NMR-Signale unterschiedlicher Resonanzfrequenz in charakteristischer Weise überlagern.

11. Verfahren nach einem der vorhergehenden Ansprüche, **dadurch gekennzeichnet, dass** HF-Impulse mit alternierendem Flipwinkel $\alpha$ bzw. Phaseninkremente von 180° gewählt werden.

12. Verfahrens nach einem der vorhergehenden Ansprüche, **dadurch gekennzeichnet, dass** HF-Impulse mit einem solchen Flipwinkel $\alpha$ gewählt werden, dass $\cos\alpha = (T1/T2 - 1) / (T1/T2 + 1)$, wobei T1 die longitudinale Relaxationszeit und T2 die transversale Relaxationszeit ohne Berücksichtigung von Suszeptibilitätseffekten bedeuten.

**Claims**

1. Method of magnetic resonance (NMR) for locally resolved measurement of the distribution of NMR signals of metabolites with low signal intensity in the form of a CSI experiment, wherein a sequence of radio frequency (RF) pulses, which are mutually offset at a time interval of a repetition time TR, is applied to a spin ensemble and magnetic gradient fields are switched, at least one of which causes local encoding of the excited spins, wherein measurement is performed without read gradient,
**characterized in that** the repetition time TR between the exciting RF pulses is selected to be at most of an order of magnitude of the transverse relaxation time T2* of the spins to be excited of a metabolite, and that the magnetic gradient fields are selected such that their action integral is zero over a repetition period of the time length TR, such that NMR signals are generated according to the principle of Steady State Free Precession (=SSFP).

2. Method according to claim 1, **characterized in that** the repetition time TR between the exciting RF pulses is selected to be approximately T2*/10.

3. Method according to any one of the preceding claims, **characterized in that** the repetition time TR is selected to be between 1 and 100ms, preferably between 5 and 20 ms.

4. Method according to any one of the preceding claims, **characterized in that** the signal recording time TAQ $<\approx$ TR is selected, preferably TAQ $\leq$ 0.95 TR.

5. Method according to claim 4, **characterized in that** NMR signal acquisition is carried out every time when no RF pulses are irradiated.

6. Method according to any one of the preceding claims, **characterized in that** RF pulses and time variant magnetic gradient fields are selected for local encoding according to the principle of the locally resolved Fourier transformation method.

7. Method according to any one of the preceding claims, **characterized in that** the excitation volume is spatially limited by simultaneously switching a magnetic gradient field and irradiating the exciting RF pulses.

8. Method according to claim 7, **characterized in that** the direction and amplitude of the slice selection gradient is changed from one recording step to the next, thereby further limiting the measuring volume to the range in which the SSFP condition is met.

9. Method according to any one of the preceding claims, **characterized in that** the NMR recording is repeated several times, thereby varying the measuring frequency, such that the signal intensities of several NMR signals of different resonance frequencies are superimposed in a characteristic fashion over the measured signal intensity as a function of the measuring frequency.

10. Method according to any one of the preceding claims, **characterized in that** the NMR recording is repeated several times between successive RF pulses, thereby varying a phase increment, such that the signal intensities of several NMR signals of different resonance frequencies are superimposed in a characteristic fashion between successive RF pulses over the measured signal intensity as a function of the phase increment.

11. Method according to any one of the preceding claims, **characterized in that** RF pulses with alternating flip angle $\alpha$ or phase increments of 180° are selected.

12. Method according to any one of the preceding claims, **characterized in that** RF pulses with a flip angle $\alpha$ are selected, such that $\cos \alpha = (T1/T2-1)/(T1/T2+1)$, wherein T1 is the longitudinal relaxation time and T2 the transverse relaxation time without taking into consideration susceptibility effects.

**Revendications**

1. Procédé de résonance magnétique (RMN) pour la mesure localisée de la répartition de signaux RMN de métabolites avec une intensité de signal faible sous la forme d'une expérience CSI, dans lequel, sur un ensemble de spins, une succession d'impulsions haute fréquence (HF) décalées les unes par rapport aux autres d'un temps de répétition TR dans un intervalle de temps est utilisée et des champs de gradients magnétiques sont créés, dont au moins un effectue un codage local du spin d'excitation, dans lequel la mesure est effectuée sans gradient de lecture, **caractérisé en ce que**

le temps de répétition TR entre les impulsions HF d'excitation est sélectionné très fréquemment dans l'ordre de grandeur du temps de relaxation transversal T2* du spin d'excitation d'un métabolite,

les champs de gradients magnétiques sont sélectionnés de sorte que leur intégrale d'action sur une période de répétition de la longueur temporelle TR est zéro, de sorte qu'une génération de signaux RMN est réalisée selon le principe de la précession libre stationnaire (SSFP).

2. Procédé selon la revendication 1, **caractérisé en ce que** le temps de répétition TR entre les impulsions HF d'excitation est choisi à environ T2*/10.

3. Procédé selon l'une des revendications précédentes, **caractérisé en ce que** le temps de répétition TR est choisi entre 1 et 100 ms, de préférence entre 5 et 20 ms.

4. Procédé selon l'une des revendications précédentes, **caractérisé en ce que** le temps d'enregistrement des signaux TAQ <= TR est choisi, de préférence TAQ $\leq$ 0,95 TR.

5. Procédé selon la revendication 4, **caractérisé en ce qu'**une acquisition de signaux RMN est toujours effectuée, lorsqu'aucune impulsion HF n'est rayonnée.

6. Procédé selon l'une des revendications précédentes, **caractérisé en ce que** les impulsions HF et les champs de gradients magnétiques variant dans le temps sont choisis pour un codage local selon le principe du procédé de transformation de Fourier localisée.

7. Procédé selon l'une des revendications précédentes, **caractérisé en ce que** le volume d'excitation est limité spatialement par commutation d'un champ de gradient magnétique simultanément avec le rayonnement des impulsions HF d'excitation.

8. Procédé selon la revendication 7, **caractérisé en ce que** la direction et l'amplitude des gradients de sélection de couche sont modifiées d'une étape d'enregistrement à l'autre, et ainsi une autre limitation du volume de mesure sur la zone, dans laquelle la condition SSFP est remplie, est effectuée.

9. Procédé selon l'une des revendications précédentes, **caractérisé en ce que** l'enregistrement RMN est répété plusieurs fois en modifiant la fréquence de mesure, de sorte que les intensités de signal de plusieurs signaux RMN de différente fréquence de résonance se superposent de manière caractéristique à l'intensité de signal mesurée en tant que fonction de la fréquence de mesure.

10. Procédé selon l'une des revendications précédentes, **caractérisé en ce que** l'enregistrement RMN est répété plusieurs fois en modifiant l'incrément de phase entre les impulsions HF successives, de sorte que les intensités de signal de plusieurs signaux RMN de différente fréquence de résonance se superposent de manière caractéristique à l'intensité de signal mesurée en tant que fonction de l'incrément de phase entre les impulsions HF successives.

11. Procédé selon l'une des revendications précédentes, **caractérisé en ce que** les impulsions HF sont choisies avec un angle de basculement $\alpha$ ou des incréments de phase de 180°.

12. Procédé selon l'une des revendications précédentes, **caractérisé en ce que** les impulsions HF sont choisies avec un angle de basculement $\alpha$ tel que cos $\alpha$ = (T1/T2-1)/(T1/T2+1), où T1 désigne le temps de relaxation longitudinal et T2 désigne le temps de relaxation transversal indépendamment des effets de susceptibilité.

Fig.1

Fig.2a

Fig.2b

12

Fig.3a

Fig.3b

Fig.4

Fig.5

Fig.6

Fig.7

17

Fig.8

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **T.R. BROWN et al.** NMR chemical shift imaging in three dimensions. *Proc. Natl. Avad. Sci. USA,* 1982, vol. 79, 3523-3526
- **CARR HY.** *Phys.Rev.,* 1958, vol. 112, 1693
- **OPPELT A et al.** *electromedica,* 1986, vol. 54, 15
- **DEIMLING M ; HEID O.** Magnetization prepared true FISP imaging. *Proceedings of the 2nd Annual Meeting of the Society of Magnetic Resonance,* 1994, 495